# FASCICULE DE BREVET EUROPEEN

(11) **EP 3 255 014 B1**
(45) Date de publication et mention de la délivrance du brevet: **12.12.2018**
(21) Numéro de dépôt: 17174823.9
(22) Date de dépôt: 07.06.2017
(51) Int. Cl.: B81B 7/00, C09D 11/52, H05K 1/09, H01Q 7/00, C09D 11/033, C09D 11/037, C09D 11/322, C09D 11/36

(54) **DISPOSITIF À PISTE ÉLECTRIQUEMENT CONDUCTRICE ET PROCÉDÉ DE FABRICATION DU DISPOSITIF**
VORRICHTUNG MIT LEITERBAHN UND HERSTELLUNGSVERFAHREN FÜR DIE VORRICHTUNG
DEVICE HAVING ELECTRICALLY CONDUCTING PATH AND METHOD FOR MANUFACTURING SAID DEVICE

(30) Priorité: 10.06.2016 FR 1655337
(43) Date de publication de la demande: 13.12.2017
(73) Titulaire: COMMISSARIAT À L'ÉNERGIE ATOMIQUE ET AUX ÉNERGIES ALTERNATIVES, 75015 Paris (FR)
(72) Inventeur: BENWADIH, Mohammed, 94500 CHAMPAGNY SUR MARNE (FR); ALIANE, Abdelkader, 38100 GRENOBLE (FR)
(74) Mandataire: GIE Innovation Competence Group

(56) Documents cités:
- EP-A1- 2 114 114
- WO-A1-2010/123733
- US-A1- 2007 221 404
- US-A1- 2011 215 279
- ZHIGANG WU ET AL: "Hemispherical coil electrically small antenna made by stretchable conductors printing and plastic thermoforming", JOURNAL OF MICROMECHANICS & MICROENGINEERING, INSTITUTE OF PHYSICS PUBLISHING, BRISTOL, GB, vol. 25, no. 2, 22 janvier 2015 (2015-01-22), page 27004, XP020278114, ISSN: 0960-1317, DOI: 10.1088/0960-1317/25/2/027004 [extrait le 2015-01-22]

## Description

### Domaine de l'Invention

Le domaine de l'invention est relatif aux pistes électriquement conductrices, notamment obtenues par impression, en particulier en vue de former une antenne ou une inductance.

### Etat de la technique

Dans le domaine de l'électronique, il est connu de former des pistes électriquement conductrices qui peuvent délimiter au moins en partie une antenne ou encore une inductance. Les techniques de dépôt de la microélectronique sont adaptées mais coûteuses et limitées à des supports rigides. Il existe donc un besoin de diminuer les coûts des opérations pour former les pistes électriquement conductrices, et de permettre la formation de telles pistes sur des supports flexibles en fonction des besoins.

Dans l'optique de diminution des coûts, il a été développé des solutions d'impression de pistes électriquement conductrices à base d'encres. Outre l'avantage de diminution des coûts, de telles encres peuvent aussi être soumises à sollicitations après leur séchage ce qui rend possible le dépôt sur substrat flexible.

Le document « Investigation of RFID tag Antennas printed on flexible substrates using two types of conductive pastes » de Kamil Janeczek et al. publié dans IEEE « Electronic System-Integration Technology Conférence (ESTC) », 2010 3rd - conférence du 13-16 Septembre 2010 qui s'est tenue à Berlin, propose d'utiliser une pâte comprenant de l'argent mélangé à un polymère. Le polymère permet une certaine flexibilité, mais présente l'inconvénient de dégrader la conductivité électrique et de créer des capacités parasites. Il en résulte la formation d'antennes de qualité moyenne. En effet, un facteur de qualité de l'antenne est dépendant de sa conductivité électrique.

De manière générale, les encres destinées à être déposées par impression et comportant de l'argent et un polymère ne sont pas sans inconvénients. En effet, le polymère agit comme un diélectrique, et la concentration des lignes de champs sous le diélectrique conduit à une chute de l'efficacité et du gain. De ce fait, cette technique n'est utilisée que lorsque l'application visée nécessite une bande passante réduite et un faible gain. De plus, une telle encre présente une grande rugosité. Il est connu que les pertes ohmiques sur les conducteurs électriques sont liées à leur conductivité électrique, mais également à la rugosité de ceux-ci comme expliqué dans le document de A. C. Scogna et M. Schauer, "Performance analysis of stripline surface roughness models," publié en 2008 dans International Symposium on Electromagnetic Compatibility - EMC Europe, 2008, pp. 1-6.

US2011/0215279 A1 divulgue un dispositif comprenant un support et une piste électriquement conductrice agencée sur le support, ladite piste électriquement conductrice comportant un ensemble de particules métalliques, des particules métalliques de l'ensemble de particules métalliques étant liées électriquement entre elles par soudure en un matériau métallique de ladite piste, ledit matériau métallique présentant une température de fusion inférieure à celle desdites particules métalliques de l'ensemble de particules métalliques.

Il existe donc un besoin de trouver une alternative par rapport à l'art antérieur, préférentiellement cette alternative peut permettre d'améliorer la conductivité d'une piste électriquement conductrice, notamment lorsque cette dernière est déposée par impression.

### Objet de l'invention

L'invention a pour but de remédier au moins en partie aux besoins évoqués précédemment.

On tend vers ce but grâce à un procédé de fabrication d'un dispositif comprenant une piste électriquement conductrice agencée sur un support, ledit procédé comportant une étape de fourniture du support, et une étape de formation de la piste électriquement conductrice sur le support comprenant les étapes suivantes : une étape de fourniture d'une solution destinée à être déposée sur le support, une étape de dépôt de la solution par impression sur le support. L'étape de fourniture de la solution est telle que ladite solution fournie comporte un mélange d'un solvant, d'un ensemble de particules métalliques et d'un matériau métallique présentant une température de fusion inférieure à celle des particules métalliques de l'ensemble de particules métalliques, et le procédé comporte une étape de fusion du matériau métallique d'où il résulte la formation d'une soudure en matériau métallique entre des particules métalliques de l'ensemble de particules métalliques.

En particulier, l'étape de formation de la piste électriquement conductrice sur le support comporte une étape de traitement thermique de la solution déposée sur le support d'où il résulte une évaporation du solvant.

Notamment, l'étape de traitement thermique comporte : une première phase dans laquelle le support et la solution déposée sont soumis à une première température comprise entre 40°C et 80°C, notamment égale à 60°C, pendant un premier temps compris entre 1 seconde et 360 secondes, notamment égal à 300 secondes, puis une deuxième phase dans laquelle le support et la solution déposée sont soumis à une deuxième température comprise entre 80°C et 120°C, notamment égale à 100°C, pendant un deuxième temps compris entre 1 seconde et 500 secondes, notamment égal à 300 secondes, puis une troisième phase dans laquelle le support et la solution déposée sont soumis à une troisième température comprise entre 100°C et 300°C, notamment égale à 140°C, pendant un troisième temps compris entre 1 seconde et 3600 secondes, notamment égal à 1800 secondes.

En particulier, il résulte de la mise en oeuvre de l'étape de traitement thermique la fusion du matériau métallique.

Selon l'invention au moins une partie du support est apte à être thermoformée, et après l'étape de formation de la piste électriquement conductrice sur le support, le procédé comporte une étape de thermoformage de ladite au moins une partie du support.

En particulier, l'étape de thermoformage provoque la fusion du matériau métallique, et après l'étape de thermoformage tout ou partie des particules métalliques de l'ensemble de particules métalliques sont soudées entre elles par ledit matériau métallique.

Notamment, l'étape de dépôt de la solution sur le support est telle qu'il est réalisé un motif destiné à délimiter au moins une partie d'antenne ou d'inductance.

De préférence, le matériau métallique est choisi parmi les alliages suivants : Ag-Bi, Ag-Sn-Bi, Ag-Sn-Cu, Au-Sn.

Le procédé peut comporter une étape de formation du support à fournir comprenant une étape de fourniture d'une base et une étape de formation d'une couche d'accroché destinée à former une interface entre la piste électriquement conductrice et la base.

L'invention est aussi relative à un dispositif comprenant un support et une piste électriquement conductrice agencée sur le support, ladite piste électriquement conductrice comportant un ensemble de particules métalliques, des particules métalliques de l'ensemble de particules métalliques étant liées électriquement entre elles par soudure en un matériau métallique de ladite piste, ledit matériau métallique présentant une température de fusion inférieure à celle desdites particules métalliques de l'ensemble de particules métalliques.

Notamment, au moins une partie du support est formée dans un matériau apte à être thermoformé.

Le matériau métallique peut être choisi parmi les alliages suivants : Ag-Bi, Ag-Sn-Bi, Ag-Sn-Cu, Au-Sn.

Les particules métalliques présentent préférentiellement des dimensions extérieures maximales comprises entre 30nm et 30µm, et préférentiellement comprises entre 1µm et 10µm.

Notamment, le support adopte une forme obtenue par thermoformage, ladite piste électriquement conductrice épousant ladite forme du support obtenue par thermoformage.

La piste électriquement conductrice peut former au moins une partie d'une antenne ou au moins une partie d'une inductance.

Par exemple, le support comporte une base et une couche d'accroché disposée sur la base et assurant un maintien de la piste électriquement conductrice sur ledit support.

### Description sommaire des figures

L'invention sera mieux comprise à la lecture de la description qui va suivre, donnée uniquement à titre d'exemple non limitatif et faite en se référant aux dessins sur lesquels :
- La figure 1 illustre un dispositif muni d'une piste électriquement conductrice selon un mode d'exécution de l'invention,
- La figure 2 représente la figure 1 selon la coupe A-A,
- La figure 3 illustre des étapes de mise en oeuvre d'un procédé selon un mode d'exécution particulier de l'invention,
- La figure 4 illustre la résistance électrique de la piste électriquement conductrice obtenue par impression et comportant d'une part que des particules d'argent, et d'autre part des particules d'argent et un matériau métallique en fonction d'une température,
- La figure 5 illustre le dispositif de la figure 1 ayant subi un thermoformage,
- La figure 6 illustre un objet électronique intégrant le dispositif de la figure 5.

Dans ces figures, les mêmes références sont utilisées pour désigner les mêmes éléments.

Par ailleurs, les éléments représentés sur les figures ne sont pas à l'échelle.

### Description de modes particuliers de réalisation

Le procédé et le dispositif décrits ci-après proposent de former par impression une piste électriquement conductrice comprenant des particules métalliques ainsi qu'un matériau métallique, notamment un alliage, utilisé préférentiellement pour souder les particules métalliques entre elles. Il en résulte l'obtention d'une piste électriquement conductrice présentant des caractéristiques, notamment de conductivité électrique, améliorées par rapport à l'art antérieur utilisant de simples particules métalliques mises en contact par un polymère. En particulier, le matériau métallique est préférentiellement choisi de sorte à présenter une température de fusion comprise dans une gamme de température appliquée pour évaporer le solvant compris dans l'encre - aussi appelée solution dans la suite de la description - utilisée lors de l'impression de la piste électriquement conductrice, ou lors d'un thermoformage du support sur lequel est formée la piste électriquement conductrice.

Dans la présente description, un alliage est une combinaison de métaux. Du point de vue de sa température de fusion un alliage peut fondre à une température plus basse que celle du moins fusible de ses constituants. La température de l'eutectique de l'alliage peut donner sa température de fusion. Pour une partie des alliages, leur température de fusion peut être même plus basse que celle du plus fusible des métaux qui composent ledit alliage (c'est par exemple vrai pour l'alliage Ag-Bi qui fond à 138°C alors que la température de fusion de Bi est égale à 271°C et que la température de fusion de Ag est égale à 960°C). C'est en général le mercure, l'étain et le bismuth qui peuvent donner de la fusibilité à l'alliage. Un alliage présente généralement une composition précise de ses constituants qui est dite « eutectique » de sorte à obtenir un point de fusion le plus bas possible pour l'alliage.

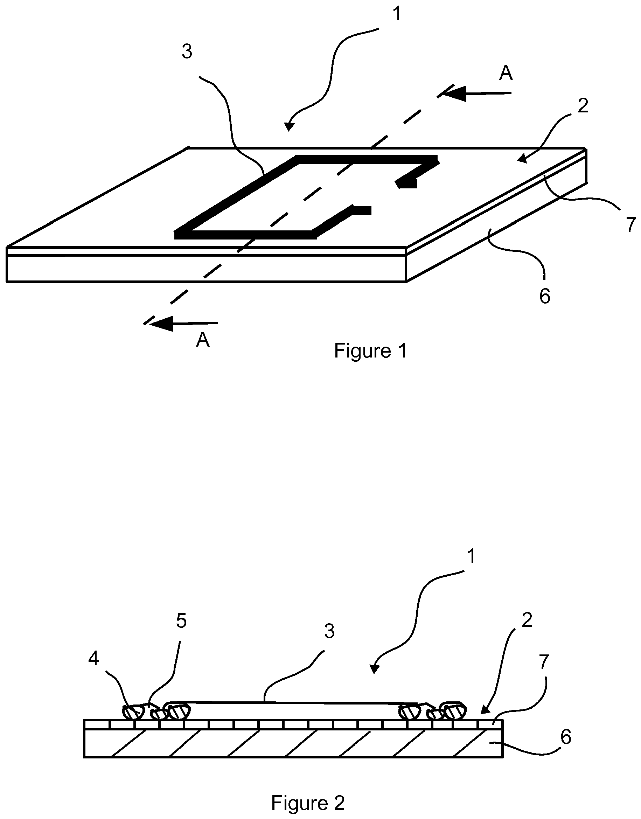

Les figures 1 et 2 illustrent un dispositif 1 comprenant un support 2 et une piste électriquement conductrice 3 agencée sur le support 2 (notamment cette piste 3 électriquement conductrice est en contact avec le support 2). La piste électriquement conductrice 3 comporte (figure 2) un ensemble de particules métalliques 4. Des particules métalliques 4 de l'ensemble de particules métalliques 4 sont liées électriquement entre elles par soudure en un matériau métallique 5 de la piste 3 électriquement conductrice. Ce matériau métallique 5 présente une température de fusion inférieure à celle des particules métalliques 4 de l'ensemble de particules métalliques 4. Par « des particules métalliques 4 de l'ensemble de particules liées électriquement entre elles par soudure en matériau métallique », on entend que le matériau métallique 5 peut assurer la continuité électrique entre tout ou partie des particules métalliques 4, contrairement au polymère de l'art antérieur. Préférentiellement, la liaison électrique est telle que l'on dit que tout ou partie des particules métalliques 4 sont soudées entre elles par le matériau métallique 5 présentant une température de fusion inférieure à la température de fusion des particules métalliques. Autrement dit, la piste 3 électriquement conductrice a pu être obtenue par fusion du matériau métallique 5 sans fonte des particules métalliques 4.

Dans la présente description, par température de fusion, on entend la température sous pression atmosphérique normale à laquelle l'élément associé fond lorsqu'il est soumis à ladite température de fusion.

La piste 3 électriquement conductrice peut former au moins une partie d'une antenne ou au moins une partie d'une inductance.

En fonction des applications, le support 2 peut être formé en tout ou partie par du polycarbonate (PC), du PC-ABS, du polyéthylène, de la céramique, de l'acier passivé, du verre, un oxyde, du SiO₂, etc.

Le fait que le matériau métallique 5 présente une température de fusion inférieure à celle des particules métalliques 4 permet des avantages quant à la conception du dispositif 1, notamment à base d'une impression en phase liquide, et peut autoriser un thermoformage du support 2 tout en conservant une bonne conduction électrique de la piste 3 électriquement conductrice après thermoformage, notamment lorsque ce dernier est effectué à une température permettant de faire fondre ledit matériau métallique 5, mais notamment pas les particules métalliques 4.

Les particules métalliques 4 de l'ensemble de particules métalliques peuvent être en argent, en or, en cuivre, en nickel, en palladium, ou encore en platine. L'argent est préféré pour sa bonne conductivité électrique et aussi car son oxyde natif est conducteur électrique. De manière générale, les particules métalliques 4 de l'ensemble de particules métalliques peuvent présenter des dimensions extérieures maximales comprises entre 30nm et 30µm, et préférentiellement comprises entre 1µm et 10µm. Ces dimensions extérieures maximales sont notamment telles qu'elles autorisent l'impression des pistes 3 électriquement conductrices : dans ce cas les particules métalliques 4 doivent pouvoir passer par exemple par des buses d'impression par jet d'encre. Les particules métalliques 4 peuvent présenter un fort module de Young. Ici, les particules étant métalliques, elles présentent effectivement un fort module de Young et par conséquent elles ne se déforment pas facilement surtout aux températures utilisées dans le cadre du procédé décrit ci-après, d'où l'intérêt de l'alliage fusible (c'est-à-dire le matériau métallique) qui à proximité de sa température de fusion se ramollie et donc encaisse parfaitement les contraintes mécaniques du fait de la chute de son module de Young quand il devient mou.

En particulier, dans le cadre de la piste 3, l'ensemble des particules métalliques 4 peut être tel que chaque particule métallique 4 est soudée par le matériau métallique 5 à au moins une autre particule métallique 4 de l'ensemble de particules métalliques. Avantageusement, le matériau métallique 5 est tel qu'il soude toutes les particules métalliques 4 de l'ensemble de particules métalliques par enrobage.

Le matériau métallique 5 peut être de l'indium dont la température de fusion est de 156°C ou encore du bismuth, de l'étain, du plomb, etc. Le matériau métallique 5 est préférentiellement un alliage de métaux. Le matériau métallique 5 est préférentiellement choisi parmi les alliages suivants : Ag-Bi (alliage d'Argent et de Bismuth), Ag-Sn-Bi (alliage d'Argent, d'Etain, et de Bismuth), Ag-Sn-Cu (alliage d'Argent, d'Etain, et de Cuivre), Au-Sn (alliage d'Or et d'Etain). Il est aussi possible d'utiliser en tant que matériau métallique un alliage d'étain et de plomb, un alliage de plomb d'étain et d'argent, un alliage d'étain de plomb et d'antimoine, un alliage d'étain de plomb et d'argent, un alliage d'étain de plomb et de cadmium, un alliage de bismuth d'étain de plomb et de cadmium, un alliage de bismuth de plomb et d'étain. L'alliage peut aussi être choisi parmi :
- de l'or à 82% et du silicium à 12%,
- un amalgame,
- un alliage de plomb à 236 parts, d'étain à 207 parts, de bismuth à 420 parts, aussi appelé alliage rose et dont la température de fusion est en dessous de 100°C,
- un alliage de plomb 3 parts, d'étain 2 parts, de bismuth 5 parts dont la température de fusion est de 91,6°C,
- un alliage de plomb 1 part, d'étain 1 part, de bismuth 2 parts dont la température de fusion est de 93°C,
- un alliage de Bismuth 8 parts, de plomb 5 parts, d'étain 3 parts qui fond dans l'eau bouillante,
- un alliage d'étain 1 part, de plomb 1 part, de bismuth 2 parts dont la température de fusion est de 94°C,
- un alliage de plomb 5 parts, d'étain 3 parts, de bismuth 8 parts dont la température de fusion est de 84, 5°C
- un alliage d'étain 17 parts, de plomb 33 parts, de Bismuth 50 parts qui fond à 94°C,
- un alliage de plomb 2 parts, d'étain 2 parts, de bismuth 7 à 8 parts, de cadmium 1 à 2 parts dont la température de fusion est entre 66°C et 71 °C,
- un alliage d'étain 15,5 parts, de plomb 30 parts, de bismuth 40 parts, de cadmium 15, 5 parts dont la température de fusion est de 71°C,
- un alliage d'étain à 13%, de plomb à 27%, de bismuth à 50% de cadmium à 10% dont la température de fusion est de 70°C,
- un alliage de bismuth 80 parts, de plomb 50 parts, d'étain 30 parts, de mercure 16 parts dont la température de fusion est de l'ordre de 65°C,
- un alliage de plomb 8 parts, d'étain 4 parts, de bismuth 15 parts, de cadmium 3 parts en pleine fusion au dessus de 60°C mais qui se ramollit entre 55°C et 60°C,
- un alliage de bismuth 50 parts, d'étain 12,5 parts, de cadmium 12,5 parts, de plomb 25 parts dont la température de fusion est de 47°C,
- un alliage d'étain à 50%, de plomb à 32% de Cadmium à 18% dont la température de fusion est de 145°C,
- un alliage d'étain à 62%, de plomb à 36%, d'argent à 2% dont la température de fusion est de 178°C,
- un alliage d'étain à 63%, de plomb à 37% dont la température de fusion est de 183°C,
- un alliage d'étain à 63%, de plomb à 36,7% et d'antimoine à 0,3% dont la température de fusion est de 183°C,
- un alliage d'étain à 60%, de plomb à 39,7% et d'antimoine à 0,3% dont la température de fusion est de 188°C,
- un alliage d'étain à 20% et d'or à 80% dont la température de fusion est de 280°C,
- un alliage de plomb à 93,5%, d'étain à 5%, d'argent à 1,5% dont la température de fusion est de 301°C,
- un alliage représenté par la formule Sn₅Pb dont la température de fusion est de 194°C,
- un alliage représenté par la formule Sn₄Pb dont la température de fusion est de 189°C,
- un alliage représenté par la formule Sn₃Pb dont la température de fusion est de 186°C,
- un alliage représenté par la formule Sn₂Pb dont la température de fusion est de 196°C,
- un alliage représenté par la formule SnPb dont la température de fusion est de 241°C,
- un alliage représenté par la formule Sn₅Pb₃ dont la température de fusion est de 289°C,
- un alliage de Darcet Bi₅₀Pb₂₅Sn₂₅ dont la température de fusion est de 94°C,
- un alliage de Newton Bi₅₀Pb₃₁Sn₁₉ dont la température de fusion est de 94°C,
- Sn₄₃Pb₄₃Bi₁₄ ou Sn₄₂Bi₅₈ avec des eutectiques fondant entre 138°C et 163°C,
- Les alliages eutectiques binaires Bi-Pb à teneur en Bi comprise entre 55% et 58% à température de fusion comprise entre 124°C et 125°C
- Un alliage appartenant à la famille des eutectiques Au-Sn dans différentes proportions (par exemple 20% d'or et 80% d'étain) présentant une température de fusion inférieure à 200°C,
- Les alliages Ag-Bi, ou autres de cette famille,
- Un des alliages suivantes Sn-Ag-Cu, Sn-Pb ou Sn-Pb-Ag

Dans la présente description, quand on parle d'une part ou d'un pourcentage, il s'agit d'une part en poids ou d'un pourcentage en poids par rapport à un poids total, notamment ici de l'alliage (donc du matériau métallique).

Les alliages listés ci-dessus sont tous compatibles avec l'utilisation de particules d'argent, le solvant utilisé dans le cadre de la solution sera juste choisi pour éviter d'être trop corrosif/agressif vis-à-vis de l'alliage et du support (notamment lorsque ledit support est en polycarbonate). Le solvant visé ici est préférentiellement anhydre (c'est à dire sans eau), et est de préférence un acide ou fortement réducteur

Concernant l'alliage, lorsque ce dernier comporte au moins l'un des constituants suivants : de l'étain, de l'argent, du cuivre ou du bismuth, il a été obtenu des résultats performants.

Selon un exemple particulier de mise en oeuvre, les particules métalliques sont des particules en argent et le matériau métallique est du Sn_{96,5}Ag₃Cu_{0,5} ce dernier matériau présente une température de fusion de 217°C et un module de Young de 41,6 Gpa.

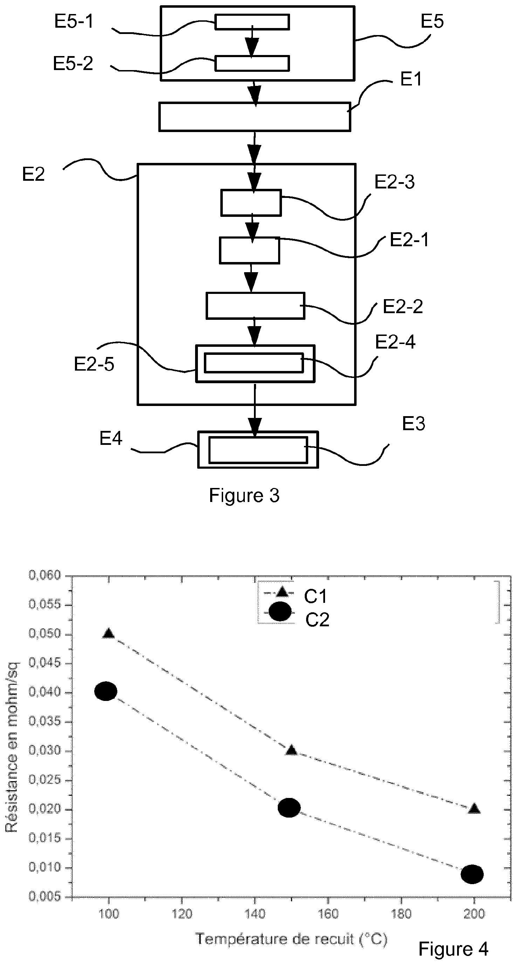

On comprend de ce qui a été dit ci-avant que l'invention est aussi relative à un procédé de fabrication d'un dispositif 1 comprenant la piste 3 électriquement conductrice agencée sur le support 2. Comme illustré en figure 3, ce procédé comporte une étape de fourniture E1 du support 2 et une étape de formation E2 de la piste 3 électriquement conductrice sur le support 2. Cette étape de formation E2 comporte les étapes suivantes : une étape fourniture E2-1 d'une solution destinée à être déposée sur le support 2 et une étape de dépôt E2-2 de la solution par impression, notamment par sérigraphie, par jet d'encre, par héliogravure ou par enduction, sur le support 2. De préférence, l'étape de dépôt E2-2 de la solution sur le support 2 est telle qu'il est réalisé un motif destiné à délimiter au moins une partie d'antenne ou d'inductance. L'étape de fourniture E2-1 de la solution est notamment telle que la solution fournie comporte un mélange d'un solvant, de l'ensemble de particules métalliques 4 et du matériau métallique 5 présentant une température de fusion inférieure à celle des particules métalliques 4 de l'ensemble de particules métalliques. Dans la présente description, la solution est liquide (du fait du dépôt par impression) et est aussi assimilée à une encre.

Le procédé (notamment l'étape E2) peut comporter une étape de préparation E2-3 de la solution à fournir comprenant la formation du mélange comprenant le solvant, les particules métalliques 4 de l'ensemble de particules métalliques et le matériau métallique 5. Notamment, le mélange peut consister en l'introduction dans un récipient du solvant, des particules métalliques 4 et d'une poudre du matériau métallique 5 ou encore du solvant, des particules métalliques 4 et d'une pâte à braser comprenant le matériau métallique 5. Autrement dit, le matériau métallique 5 intégré à la solution peut se présenter, avant d'être mélangé à ladite solution, sous la forme d'une poudre d'un alliage métallique, ou ledit matériau métallique 5 est présent au sein d'une pâte à braser ajoutée à ladite solution. Le rôle du solvant et de mouiller et de fluidifier le mélange pour obtenir une solution apte à être déposée par impression, par exemple par jet d'encre ou par sérigraphie. Idéalement, le solvant présente une tension de vapeur très basse à température ambiante, afin de minimiser le séchage sur le support 2, mais permettant son évaporation dans un temps raisonnable notamment à une température de l'ordre de 150°C. On utilise donc en tant que solvant des substances à haut point d'évaporation telles que l'éthylène glycol ou un autre alcool. Le matériau métallique 5, aussi appelé liant fusible est choisi pour garantir la cohésion de la couche formant la piste 3 électriquement conductrice à l'état sec, après évaporation du solvant. À l'état humide, notamment lorsqu'il se présente sous forme de pâte à braser, le matériau métallique 5 est dispersé dans le solvant et en augmente la viscosité, et peut influencer la rhéologie de la pâte, que l'on veut thixotrope (viscosité plus faible à cisaillement élevé). Par ailleurs, le mélange peut aussi comporter des agents dispersant évitant l'agglomération ou la sédimentation du matériau métallique 5 sous forme de poudre ou de pâte à braser. Les agents visés ci-dessus peuvent être des tensio-actifs comme le terpinéol ou des Surfynol®.

Afin d'améliorer la conductivité électrique de la piste 3 électriquement conductrice, le procédé comporte (figure 3) une étape de fusion E2-4, E3 du matériau métallique 5 d'où il résulte la formation d'une soudure en matériau métallique 5 entre des particules métalliques 4 de l'ensemble de particules métalliques. Bien entendu, cette étape de fusion E2-4, E3 peut être mise en oeuvre après dépôt de la solution sur le support 2. Comme il le sera vu par la suite, il peut être mise en oeuvre une première étape de fusion E2-4 notamment de manière concomitante à l'évaporation du solvant et/ou une deuxième étape de fusion E3 de manière concomitante à une étape de thermoformage du support 2. On comprend par ailleurs qu'au terme de l'étape de formation de la piste 3 ou plus généralement au terme du procédé de fabrication du dispositif, la piste 3 comporte préférentiellement des particules métalliques soudées entre elles par du matériau métallique 5, cette soudure étant résultante de l'étape de fusion.

Selon une mise en oeuvre, l'étape de formation E2 de la piste 3 électriquement conductrice sur le support 2 comporte une étape de traitement thermique E2-5 de la solution déposée sur le support 2 d'où il résulte une évaporation du solvant. En ce sens, au terme de l'évaporation du solvant il est possible d'obtenir la piste 3 électriquement conductrice, et préférentiellement dont des particules 4 métalliques sont soudées entre elles par du matériau métallique 5 assurant ainsi une bonne conductivité électrique de la piste 3 électriquement conductrice. On comprend que l'homme du métier sera à même de choisir le mélange pour qu'il soit adapté à une telle étape de traitement thermique. Par ailleurs, on comprend aussi qu'il résulte préférentiellement de la mise en oeuvre de l'étape de traitement thermique E2-5 la fusion du matériau métallique : on dit alors que l'étape de traitement thermique met en oeuvre ladite étape de fusion E2-4 du matériau métallique.

De préférence, l'étape de préparation de la solution - et donc la solution fournie - est telle que pour la masse formée par les particules métalliques 4 de l'ensemble de particules métalliques et le matériau métallique 5, ledit matériau métallique représente entre 1% et 25% en poids de la masse, et préférentiellement entre 1% à 10% en poids de la masse, le reste étant formé par lesdites particules métalliques 4. Plus le pourcentage en poids du matériau métallique 5 augmente, plus il a été constaté un enrobage des particules métalliques 4 consécutivement à l'étape de fusion E2-4, E3 et ce notamment dans l'exemple évoqué ci-dessus à base de particules d'argent et de Sn_{96,5}Ag₃Cu_{0,5}. Lors de l'utilisation de particules métalliques 4 en argent avec le matériau métallique 5 formé par Sn_{96,5}Ag₃Cu_{0,5}, il a été constaté qu'entre 5 % et 10% de matériau métallique 5 au sein de la masse, il était réalisé des soudures entre particules métalliques 4 selon un premier état dans lequel les particules métalliques 4 ne sont pas entièrement recouvertes par du matériau métallique 5 et que lorsque le pourcentage devenait supérieur à 10% il était réalisé des soudures, selon un deuxième état, enrobant les particules d'argent entre elles. On comprend que plus on augmente la quantité de matériau métallique 5, plus les soudures obtenues par la fusion de ce dernier vont remplir les espaces entre les particules métalliques 4 jusqu'à toutes les enrober au sein d'une couche en matériau métallique 5 si la quantité dudit matériau métallique le permet. Autrement dit, la composition de la solution peut être choisi de sorte que l'étape de fusion correspondante du matériau métallique soit telle qu'à son terme, et après solidification du matériau métallique, il soit réalisé une soudure enrobant les particules métalliques ou laissant des surfaces de particules métalliques non recouverte de matériau métallique. Le choix de la soudure dépend de la conductivité électrique des particules métalliques, en effet on favorise la plus grande surface à l'élément qui donne la meilleure conductivité électrique à l'ensemble : si les particules métalliques sont plus conductrices électriquement que le matériau métallique, la soudure sera préférentiellement réalisée telle qu'elle laisse des surfaces de particules métalliques non recouverte de matériau métallique, et inversement si le matériau métallique est plus conducteur électriquement que les particules métalliques la soudure sera réalisée préférentiellement telle que le matériau métallique 5 enrobe totalement les particules métalliques 4 après soudage.

La figure 4 représente la résistance électrique en mohm/sq ou mohm/carré en fonction de la température (appelée température de recuit) liée à l'étape de traitement thermique appliquée pendant 30 minutes pour faire évaporer le solvant pour une encre comportant seulement des particules d'argent (courbe C1), et pour une encre comportant des particules d'argent mélangées au matériau métallique (Courbe C2). Dans le cadre de la figure 4, les particules métalliques sont en argent de taille d'environ 400nm à 1µm et représentent 90% en poids de la masse formée par les particules d'argent et le matériau métallique. Par ailleurs, ici les particules métalliques sont mélangées à 10% en poids de ladite masse avec un alliage fusible de type Ag-Sn-Cu. La solution est déposée par sérigraphie, et la température appliquée ensuite varie entre 100 et 200°C. L'épaisseur de la métallisation obtenue (c'est-à-dire la piste électriquement conductrice) est d'environ 101µm.

Dans le cas de l'encre seule (courbe C1), après évaporation du solvant, les particules se touchent, réalisant ainsi des contacts électriques ponctuels entre elles. Dans le cas de l'encre comportant des particules d'argent 4 mélangées au matériau métallique 5 (courbe C2), le matériau métallique 5 vient souder les particules 4 entre elles au terme de l'évaporation du solvant réalisant ainsi une étape de fusion correspondante. On s'aperçoit à la lecture de cette figure 4 que l'utilisation du mélange selon la présente invention permet l'obtention de meilleurs résultats que les particules d'argent seules.

Par ailleurs, il a été mis en avant lors de l'étape de traitement thermique E2-5 que l'application d'un protocole utilisant plusieurs paliers différents en température permettait d'obtenir une conductivité électrique encore meilleure. Selon ce protocole, l'étape de traitement thermique E2-5 comporte une première phase dans laquelle le support 2 et la solution déposée sont soumis à une première température comprise entre 40°C et 80°C, notamment égale à 60°C, pendant un premier temps compris entre 1 seconde et 360 secondes, notamment égal à 300 secondes. Cette première phase permet notamment d'éviter de monter trop rapidement à la température d'ébullition de certains solvants et d'éviter la création de cratères ou de trous dans la couche que l'on cherche à former (c'est à dire la piste) lors de l'évaporation brutale du solvant. La première phase permet d'évaporer un ou des alcools qui peuvent être présents dans le solvant de la solution, le ou les alcools s'évaporant au cours de la première phase peuvent être choisis parmi l'éthanol, l'isopropanol, il est possible que la solution contienne aussi de l'acétone, utilisée comme solvant, à évaporer au cours de la première phase. L'étape de traitement thermique E2-5 comporte, après la première phase, une deuxième phase dans laquelle le support 2 et la solution déposée sont soumis à une deuxième température comprise entre 80°C et 120°C, notamment égale à 100°C, pendant un deuxième temps compris entre 1 seconde et 500 secondes, notamment égal à 300 secondes. Cette deuxième phase permet de figer une composition homogène notamment entre du mélange Ag (particules métalliques) et brasure (matériau métallique). Par ailleurs, cette deuxième phase permet d'évaporer une partie du solvant présentant un point d'ébullition plus élevé comme par exemple supérieur à 100°C, cette partie du solvant peut alors comporter à titre d'exemple du cyclopentanone, et/ou du butyrolactone, et/ou du toluène. Notamment, cette deuxième phase ne détériore pas l'aspect des particules métalliques. Enfin, l'étape de traitement thermique E2-5 comporte, après la deuxième phase, une troisième phase dans laquelle le support et la solution déposée sont soumis à une troisième température comprise entre 100°C et 300°C, notamment égale à 140°C, pendant un troisième temps compris entre 1 seconde et 3600 secondes, notamment égal à 1800 secondes. Cette troisième phase permet notamment d'évaporer les restes de solvant et des résidus organiques et le cas échéant faire fondre le matériau métallique 5 (c'est à dire que l'on constate la mise en oeuvre une étape de fusion E2-4) qui doit donc être convenablement choisi. Ainsi, la troisième phase peut permettre de connecter les particules métalliques entre elles. Ce protocole est fonctionnel avec la plupart des matériaux qui seront choisis en fonction des températures mises en jeu, seul le substrat est limitant, par exemple le polycarbonate résiste seulement à 140°C maximum : il faudra donc adapter le protocole aussi en fonction du support 2. Par exemple, le protocole s'applique lorsque le support 2 est un support, notamment flexible, en polycarbonate ou en polyéthylène naphtalène.

Il a été évoqué précédemment un thermoformage du support 2. Le thermoformage du support 2 peut être intéressant dans des applications où l'on cherche à intégrer la piste électriquement conductrice (par exemple une antenne) à l'intérieur d'un appareil électronique (téléphone, Pager, ...). Au lieu d'imprimer directement la piste électriquement conductrice 3 sur un circuit imprimé, l'idée est de la miniaturiser pour l'intégrer dans un module spécifiquement dédié par exemple sur un support à base de plastique. Le thermoformage est une technique qui consiste à prendre un matériau sous forme de plaque (dans notre cas préférentiellement un plastique), à le chauffer pour le ramollir, et à profiter de cette ductilité pour le mettre en forme avec un moule. Le matériau redurcit lorsqu'il refroidit, gardant la forme souhaitée pour son intégration. Dans le cas du thermoformage plastique, le matériau utilisé se présente le plus souvent sous forme d'une feuille en plastique comprenant l'antenne que l'on thermoforme sur une coque plastique généralement en ABS (acronyme de acrylonitrile butadiène styrène) ou PC (acronyme de polycarbonate)/ABS ou ABS/PC. Le thermoformage est basé sur le phénomène de transition vitreuse des thermoplastiques. En effet, leur température de transition vitreuse passée, les thermoplastiques sont à l'état de caoutchouc, il devient alors facile de leur donner une nouvelle forme. Une fois la température descendue en dessous de la transition vitreuse, le polymère retourne à l'état solide c'est-à-dire vitreux. Le thermoformage se déroule selon les phases suivantes : chauffage de la matière ; mise en forme de la matière sur un moule adapté (par le vide, sous pression...) ; refroidissement (la pièce reste sur le moule) ; démoulage et évacuation de la pièce finale. L'un des principaux avantages du thermoformage est la relative rapidité à lancer une production par rapport à l'injection.

Dans le cadre d'un thermoformage du support 2, on propose ici d'utiliser la température appliquée au support 2 pour d'une part ramollir le support 2 en vue de lui donner une forme particulière, et d'autre part préférentiellement faire fondre le matériau métallique (à nouveau s'il a déjà fondu lors de l'étape de traitement E2-5 permettant l'évaporation du solvant) d'où il résulte qu'après thermoformage des particules métalliques 4 sont à nouveau soudées par du matériau métallique 5 malgré les contraintes appliquées au support 2 pour la mise en forme. En ce sens, on conserve une très bonne conductivité de la piste électriquement conductrice même après thermoformage. Pour réaliser le thermoformage, le support 2 peut être au moins en partie formé par un matériau ductile et thermoformable aux alentour de 140°C comme le polycarbonate ou le polyéthylène. Bien que l'alliage Ag-Bi devienne liquide à cette température de thermoformage cela n'est pas grave car il reste lié/emprisonné entre les particules métalliques d'argent et ressoude le tout lors du refroidissement.

Plus généralement, dans le cadre du procédé, lorsque au moins une partie du support 2 (voire tout le support 2) est apte à être thermoformée, après l'étape de formation E2 de la piste 3 sur le support 2, le procédé comporte une étape de thermoformage E4 de ladite au moins une partie du support 2. Cette étape de thermoformage E4 peut être mise en oeuvre après l'étape de fusion E2-4 décrite ci-avant, notamment lorsqu'elle est mise en oeuvre au cours de l'étape de traitement thermique E2-5, ou cette étape peut être telle qu'elle met en oeuvre pour la première fois l'étape de fusion E3 du matériau métallique 5. On comprend de ce qui a été dit ci-dessus que le matériau métallique 5 peut subir une ou deux fusions selon les cas, dans le cadre du thermoformage il peut s'agir de la première fusion ou de la deuxième fusion, en particulier l'évaporation du solvant de la solution peut ne pas provoquer la fusion du matériau métallique. L'étape de thermoformage E4 peut aussi être telle qu'elle ne permet pas la fusion du matériau métallique 5, notamment si ce dernier a déjà fusionné au cours de l'étape de traitement E2-5 et est capable d'encaisser les contraintes mécaniques liées au thermoformage sans rompre et casser les liaisons électriques entre particules métalliques 4 réalisées par fusion au cours de l'étape E2-5.

Selon une réalisation, on dit que l'étape de thermoformage E4 provoque la fusion E3 du matériau métallique 5 (c'est-à-dire que l'étape de thermoformage E4 provoque la mise en oeuvre de l'étape de fusion E3 du matériau métallique 5), et après l'étape de thermoformage E4 tout ou partie des particules métalliques 4 de l'ensemble de particules métalliques sont soudées entre elles par ledit matériau métallique 5 ayant repris une forme solide, les soudures au terme de l'étape de thermoformage peuvent être telles que celles décrites ci-avant. On comprend ici que l'étape de thermoformage E4 comporte l'application d'une température de thermoformage choisie pour, d'une part, permettre la déformation du support 2, et le cas échéant, d'autre part, permettre la fusion du matériau métallique 5. Au terme de l'étape de thermoformage, le support 2 conserve la forme à laquelle il a été contraint, la piste 3 pouvant épouser cette forme. Selon cette réalisation, on distingue deux cas, soit le procédé comporte une seule étape de fusion E3 du matériau métallique 5 mise en oeuvre par l'étape de thermoformage E4, soit le procédé comporte deux étapes de fusion E2-4 et E3 du matériau métallique 5 respectivement nommées première étape de fusion E2-4 et deuxième étape de fusion E3, la première étape de fusion E2-4 étant réalisée pendant l'étape de traitement thermique E2-5 du fait de la température appliquée pour évaporer le solvant et la deuxième étape de fusion E3 étant réalisée pendant l'étape de thermoformage du fait de la température appliquée pour thermoformer le support 2.

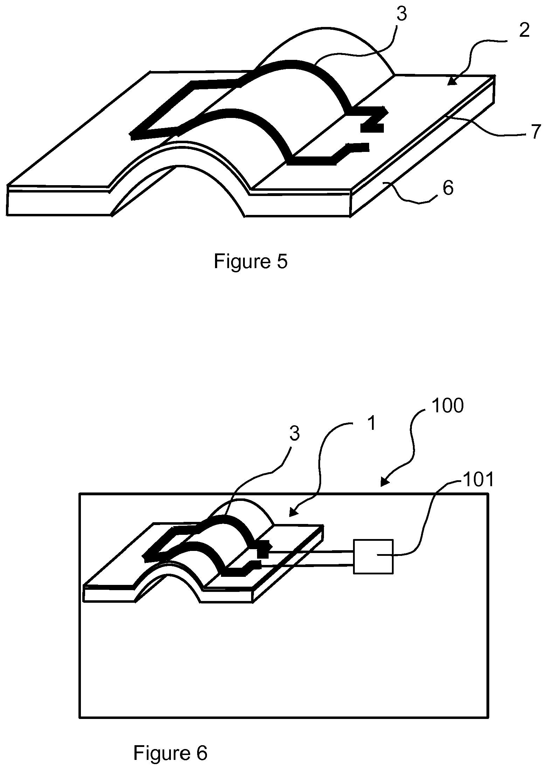

Dans le cadre du dispositif, ce dernier peut être tel qu'au moins une partie du support 2 est formée par un matériau apte à être thermoformé, ou encore que le support 2 adopte une forme obtenue par thermoformage, ladite piste 3 électriquement conductrice épousant ladite forme du support 2 obtenue par thermoformage (figure 5).

Dans le cadre du thermoformage, on comprend bien entendu qu'il faut choisir un matériau métallique 5 dont la fusion peut être obtenue lorsque la température de thermoformage du support 2 est appliquée. Si le support est à base de polycarbonate, sa température de thermoformage est de 150°C, dans ce cas le matériau métallique choisi le sera pour être fusible à des températures allant de 90°C à 170°C, lorsque le matériau métallique présente une température de fusion supérieure à la température de thermoformage son utilisation est quand même possible car les hautes températures (par exemple 170°C) pendant le thermoformage ne durent seulement que quelques secondes, le PC peut être utilisé jusqu'à cette température. Ceci permet de garantir une conductivité élevée et un bon comportement mécanique de la piste 3 électriquement conductrice pendant le thermoformage. Comme évoqué précédemment, il n'est pas obligé d'aller jusqu'à la fusion du matériau métallique 5 du moment qu'il peut encaisser les contraintes mécaniques et que ce dernier a déjà fusionné au cours de l'étape E2-5 par la mise en oeuvre de l'étape de fusion E2-4 associée. Cependant, pour obtenir une faible rugosité et une conductivité électrique finale élevée de la piste 3 électriquement conductrice déformée au cours du thermoformage, il est préférable d'aller à la fusion du matériau métallique : en effet, une bonne soudure entre le matériau métallique 5 et les particules métalliques 4 permet d'obtenir un bon contact électrique et donc une grande surface de contact.

Le chauffage pour amener à la fusion (que cela soit au cours de l'étape E2-5 et/ou de l'étape de thermoformage E4), peut se faire avec différentes méthodes : soit par recuit sur une plaque chauffante, soit par un recuit à base d'impulsions (Flash UV), soit par un recuit micro-ondes, soit par un recuit électrique (activation joule).

De manière plus générale, la fusion du matériau métallique 5 est telle qu'il forme une brasure assurant une liaison intermétallique entre ladite brasure et des particules métalliques 4. Le matériau métallique 5 est choisi de sorte que sa fonte évite la surchauffe d'autres éléments du dispositif pour éviter de détériorer ces autres éléments. La quantité du matériau métallique 5 peut être choisie de sorte à utiliser un minimum de matériau métallique 5 pour assurer les liaisons intermétalliques : on ne cherche pas à noyer les particules métalliques dans une couche de matériau métallique. En ce sens, la concentration de particules métalliques 4 par rapport au matériau métallique 5 peut dépendre des contraintes mécaniques en particulier mises en oeuvre lors du thermoformage et de la température de thermoformage.

On comprend que les avantages d'utilisation d'un mélange tel que décrit dans le cadre du procédé et d'une telle piste 3 électriquement conductrice dans le cadre du dispositif sont nombreux. Par exemple, après recuit de la solution, le matériau métallique 5 forme un alliage fusible soudant les particules métalliques 4 entre elles et permettant d'obtenir des conductivités électriques proches de celle d'un matériau massif sans défauts. La phase fusible du matériau métallique 5 est destinée à conserver en partie les caractéristiques mécaniques et électriques lors du thermoformage de la piste 3 électriquement conductrice ayant la capacité à se déformer plastiquement lors de contacts intenses et lors de la montée en température afin de permettre la soudure de la phase fusible à la surface des particules métalliques 4 pour obtenir une continuité électrique de la couche formant la piste 3 électriquement conductrice après thermoformage. L'utilisation de matériaux métalliques issus des technologies du brasage est certainement une technique d'assemblage des particules métalliques 4 parmi celle qui confère les meilleures performances électriques à la solution recuite (évaporation du solvant) et thermoformée. Le matériau métallique 5 forme des joints de soudure constitués par une liaison métallurgique des métaux à assembler, résultant de la solidification de la brasure car son point de fusion est toujours inférieur à celui des particules d'argent en présence. Ce matériau métallique 5 aussi appelé métal d'apport, qui est par exemple à base d'indium (In), ou à base d'alliages Sn-Pb, Au-Sn, etc., est amené à l'état liquide (fusion de ce dernier) par une source de chaleur, pénètre par capillarité entre les bords des surfaces des particules métalliques 4 en remplissant tous les interstices, et s'incruste préférentiellement littéralement dans la couche superficielle du support 2. Ce matériau métallique sert au mouillage intégral des surfaces par l'alliage fondu et sans lequel il est impossible d'assurer une réelle continuité électrique de la piste 3. L'aptitude au brasage est intimement liée au fait que l'alliage mouille bien les surfaces et cette propriété très complexe.

Dans certains cas, notamment dans le cas de la formation de la piste 3 électriquement conductrice sur un support 2 thermodéformable, il peut être avantageux d'améliorer l'adhérence de la piste 3 électriquement conductrice. L'adhérence peut être améliorée notamment si le support comporte - ou est constitué par - du polycarbonate, du SiO₂ ou un oxyde (le matériau de base du support sera choisi en fonction du choix ou non de la mise en oeuvre de l'étape de thermoformage), grâce à l'utilisation d'une couche d'accroché. Cette couche d'accroché peut être utilisée que l'on souhaite réaliser ou non par la suite un thermoformage si le support 2 le permet : une solution adhérente est toujours plus intéressante qu'une solution non adhérente. La couche d'accroché est néanmoins préférée lorsque l'on réalise un thermoformage du support 2 pour améliorer le maintien de la piste sur le support 2 au cours du thermoformage. Plus généralement, dans le cadre du procédé ce dernier peut comporter une étape de formation E5 (figure 3) du support 2 à fournir comprenant une étape de fourniture E5-1 d'une base, notamment en polycarbonate ou en SiO₂ ou en oxyde, et une étape de formation E5-2 d'une couche d'accroché 7 destinée à former une interface entre la piste 3 électriquement conductrice et la base 6 (figures 1, 2, et 5). Pour cela, la couche d'accroché 7 peut comporter un thiol et un méthoxy, le groupement thiol assure l'accroche avec les particules métalliques 4, notamment en argent (bien que le groupement thiol soit aussi compatible avec les autres matériaux cités pour former les particules métalliques), et/ou le matériau métallique 5, notamment lorsqu'il comporte de l'argent ou autres métaux tels que visés précédemment, et le groupement methoxy assure l'accroche sur la base notamment en polycarbonate ou en SiO2 ou en oxyde. La couche d'accroché 7 peut être formée en HSCH₂(CH₂)₉CH₂OH, en 4mercapto-1-butanol, en 5-Amino-1, 3, 4-thiadiazole-2-thiol qui présentent l'avantage de rester stable à 140°C, d'autres couches d'accroché en autres matériaux peuvent être utilisées mais risquent d'être moins efficaces. Dans le cadre du dispositif, on dit que le support 2 peut comporter une base 6 et une couche d'accroché 7 disposée sur la base 6 et assurant un maintien de la piste 3 électriquement conductrice sur ledit support 2, et notamment même au cours du thermoformage dudit support 2. Autrement dit, la couche d'accroché 7 présente des affinités avec le matériau de la base 6 du support et ceux de la piste 3 pour assurer une bonne liaison mécanique entre la base 6 et la piste 3. La couche d'accroché 7 peut aussi comporter un groupement carboxylique ou un groupement comprenant HSONH2. Dans le cadre où l'on souhaite réaliser une couche d'accroché sans qu'il y ait thermoformage du support par la suite, il peut être utilisé du Al2O3 en tant que couche d'accroché 7.

La présente invention est tout particulièrement adaptée pour former une antenne ou une inductance à partir de la piste 3 électriquement conductrice dont le paramètre essentiel est la conductivité électrique qui doit être la plus grande possible. En particulier, la piste électriquement conductrice peut comporter une conductivité électrique comprise entre 10⁵ et 10⁶ S.m⁻¹ et ce même après thermoformage du support. Notamment, l'antenne formée à partir de la piste peut être une antenne filaire, une antenne à fente, une antenne à patch, une antenne à ouverture, une antenne à réflecteur, etc., dont le design peut être adapté par l'homme du métier.

Par ailleurs, l'utilisation d'un matériau métallique 5 ayant fusionné pour former, avec les particules métalliques 4, la piste 3 électriquement conductrice permet à cette dernière de présenter une faible rugosité ce qui présente un avantage, notamment dans le cadre des antennes. En effet, comme la conduction électrique se fait sur la peau du dépôt (courant de surface de la piste métallique), la rugosité devient importante pour les hautes fréquences : il faut que la surface soit plane pour avoir un bon rendement entre l'onde électromagnétique et le courant créés dans la piste métallique.

Les particules métalliques 4 sont notamment telles que, lors de la mise en oeuvre du procédé, elles ne sont pas entrées en fusion, gardant ainsi leur forme d'origine.

Tout ce qui a été dit en relation avec le dispositif peut s'appliquer au procédé de fabrication du dispositif et tout ce qui a été dit en relation avec le procédé peut s'appliquer au dispositif. Par ailleurs, le procédé peut être tel qu'il permet la formation simultanée d'une pluralité de dispositifs tels que décrits qui partagent un même support 2 avant d'être individualisés.

On comprend de ce qui a été dit ci-avant qu'il est possible d'obtenir des antennes de différentes formes aptes à épouser tout type de surface, permettant ainsi de faciliter leurs intégrations. Autrement dit, l'invention est aussi relative à un objet électronique 100 (figure 6), notamment communicant de type téléphone portable, comportant le dispositif 1 tel que décrit. En particulier, la piste 3 électriquement conductrice forme au moins une partie d'une antenne reliée à un module 101 d'émission et/ou de réception ou forme au moins une partie d'une inductance. Notamment, le dispositif 1 est conformé par thermoformage de sorte à épouser une partie de l'objet électronique par exemple une coque, notamment en plastique, d'habillage de ce dernier.

De manière générale, la solution déposée, et la piste électriquement conductrice résultante, présentent des dimensions et des compositions adaptées à l'application (inductance ou antenne). En particulier, après dépôt de la solution, l'épaisseur de solution déposée peut être comprise entre 500µm et 2mm, pour une largeur comprise entre 50µm et 150µm (et préférentiellement égale à 100µm). Une fois la piste réalisée, c'est à dire notamment après évaporation du solvant, la piste peut présenter une épaisseur comprise entre 5µm et 30µm, pour une largeur de l'ordre de 100µm. En outre, la piste électriquement conductrice peut être telle que les particules métalliques sont reliées électriquement entre elles par le matériau métallique. La piste électriquement conductrice peut comporter un empilement de particules métalliques reliées entre elles électriquement par soudure en matériau métallique 5.

L'utilisation du thermoformage est préférée dans les applications d'antenne, dans les applications d'inductance le support ne sera préférentiellement pas thermoformé.

## Revendications

1. Procédé de fabrication d'un dispositif (1) comprenant une piste (3) électriquement conductrice agencée sur un support (2), ledit procédé comportant une étape de fourniture (E1) du support (2), et une étape de formation (E2) de la piste (3) électriquement conductrice sur le support (2) comprenant les étapes suivantes :
- une étape de fourniture (E2-1) d'une solution destinée à être déposée sur le support (2),
- une étape de dépôt (E2-2) de la solution par impression sur le support (2), l'étape de fourniture (E2-1) de la solution étant telle que ladite solution fournie comporte un mélange d'un solvant, d'un ensemble de particules métalliques (4) et d'un matériau métallique (5) présentant une température de fusion inférieure à celle des particules métalliques (4) de l'ensemble de particules métalliques, ledit procédé comportant une étape de fusion (E2-4, E3) du matériau métallique (5) d'où il résulte la formation d'une soudure en matériau métallique (5) entre des particules métalliques (4) de l'ensemble de particules métalliques,
**caractérisé en ce qu'**au moins une partie du support (2) est apte à être thermoformée, et **en ce qu'**après l'étape de formation (E2) de la piste (3) électriquement conductrice sur le support (2), le procédé comporte une étape de thermoformage (E4) de ladite au moins une partie du support (2).

2. Procédé selon la revendication précédente, **caractérisé en ce que** l'étape de formation (E2) de la piste (3) électriquement conductrice sur le support (2) comporte une étape de traitement thermique (E2-5) de la solution déposée sur le support (2) d'où il résulte une évaporation du solvant.

3. Procédé selon la revendication précédente, **caractérisé en ce que** l'étape de traitement thermique (E2-5) comporte :
• une première phase dans laquelle le support (2) et la solution déposée sont soumis à une première température comprise entre 40°C et 80°C, notamment égale à 60°C, pendant un premier temps compris entre 1 seconde et 360 secondes, notamment égal à 300 secondes, puis
• une deuxième phase dans laquelle le support (2) et la solution déposée sont soumis à une deuxième température comprise entre 80°C et 120°C, notamment égale à 100°C, pendant un deuxième temps compris entre 1 seconde et 500 secondes, notamment égal à 300 secondes, puis
• une troisième phase dans laquelle le support (2) et la solution déposée sont soumis à une troisième température comprise entre 100°C et 300°C, notamment égale à 140°C, pendant un troisième temps compris entre 1 seconde et 3600 secondes, notamment égal à 1800 secondes.

4. Procédé selon l'une quelconque des revendications 2 à 3, **caractérisé en ce qu'**il résulte de la mise en oeuvre de l'étape de traitement thermique la fusion (E2-4) du matériau métallique (5).

5. Procédé selon l'une quelconque des revendications précédentes, **caractérisé en ce que** l'étape de thermoformage (E4) provoque la fusion (E3) du matériau métallique (5), et **en ce qu'**après l'étape de thermoformage (E4) tout ou partie des particules métalliques (4) de l'ensemble de particules métalliques sont soudées entre elles par ledit matériau métallique (5).

6. Procédé selon l'une quelconque des revendications précédentes, **caractérisé en ce que** l'étape de dépôt (E2-2) de la solution sur le support (2) est telle qu'il est réalisé un motif destiné à délimiter au moins une partie d'antenne ou d'inductance.

7. Procédé selon l'une quelconque des revendications précédentes, **caractérisé en ce que** le matériau métallique (5) est choisi parmi les alliages suivants : Ag-Bi, Ag-Sn-Bi, Ag-Sn-Cu, Au-Sn.

8. Procédé selon l'une quelconque des revendications précédentes, **caractérisé en ce qu'**il comporte une étape de formation (E5) du support (2) à fournir comprenant une étape de fourniture (E5-1) d'une base et une étape de formation (E5-2) d'une couche d'accroché (7) destinée à former une interface entre la piste (3) électriquement conductrice et la base (6).

9. Dispositif (1) comprenant un support (2) et une piste (3) électriquement conductrice agencée sur le support (2), ladite piste (3) électriquement conductrice comportant un ensemble de particules métalliques (4), des particules métalliques (4) de l'ensemble de particules métalliques étant liées électriquement entre elles par soudure en un matériau métallique (5) de ladite piste (3), ledit matériau métallique (5) présentant une température de fusion inférieure à celle desdites particules métalliques (4) de l'ensemble de particules métalliques, **caractérisé en ce que** le support (2) adopte une forme obtenue par thermoformage, ladite piste (3) électriquement conductrice épousant ladite forme du support (2) obtenue par thermoformage.

10. Dispositif selon la revendication précédente, **caractérisé en ce qu'**au moins une partie du support (2) est formée dans un matériau apte à être thermoformé.

11. Dispositif selon l'une quelconque des revendications 9 à 10, **caractérisé en ce que** le matériau métallique est choisi parmi les alliages suivants : Ag-Bi, Ag-Sn-Bi, Ag-Sn-Cu, Au-Sn.

12. Dispositif selon l'une quelconque des revendications 9 à 11, **caractérisé en ce que** les particules métalliques présentent des dimensions extérieures maximales comprises entre 30nm et 30µm, et préférentiellement comprises entre 1µm et 10µm.

13. Dispositif selon l'une quelconque des revendications 9 à 12, **caractérisé en ce que** la piste électriquement conductrice (3) forme au moins une partie d'une antenne ou au moins une partie d'une inductance.

14. Dispositif selon l'une quelconque des revendications 9 à 13, **caractérisé en ce que** le support (2) comporte une base (6) et une couche d'accroché (7) disposée sur la base (6) et assurant un maintien de la piste (3) électriquement conductrice sur ledit support (2).

## Patentansprüche

1. Verfahren zur Herstellung einer Vorrichtung (1), die eine elektrisch leitende Bahn (3) umfasst, die auf einem Träger (2) angeordnet ist, wobei das Verfahren einen Schritt des Lieferns (E1) des Trägers (2) und einen Schritt des Bildens (E2) der elektrisch leitenden Bahn (3) auf dem Träger (2) umfasst, das die folgenden Schritte umfasst:
- einen Schritt des Lieferns (E2-1) einer Lösung, die dazu bestimmt ist, auf dem Träger (2) abgeschieden zu werden,
- einen Schritt des Abscheidens (E2-2) der Lösung durch Drucken auf den Träger (2),
wobei der Schritt des Lieferns (E2-1) der Lösung derart ist, dass die gelieferte Lösung ein Gemisch eines Lösemittels, einer Einheit metallischer Partikel (4) und eines metallischen Materials (5), das eine Schmelztemperatur aufweist, die niedriger ist als die der metallischen Partikel (4) der Einheit metallischer Partikel, umfasst, wobei das Verfahren einen Schmelzschritt (E2-4, E3) des metallischen Materials (5) umfasst, aus dem das Bilden einer Schweißung aus metallischem Material (5) zwischen den metallischen Partikeln (4) der Einheit metallischer Partikel resultiert, **dadurch gekennzeichnet, dass** mindestens ein Teil des Trägers (2) geeignet ist, thermogeformt zu werden, und dass das Verfahren nach dem Schritt des Bildens (E2) der elektrisch leitenden Bahn (3) auf dem Träger (2) einen Thermoformungsschritt (E4) mindestens eines Teils des Trägers (2) umfasst.

2. Verfahren nach dem vorhergehenden Anspruch, **dadurch gekennzeichnet, dass** der Schritt des Bildens (E2) der elektrisch leitenden Bahn (3) auf dem Träger (2) einen Wärmebehandlungsschritt (E2-5) der Lösung, die auf dem Träger (2) abgeschieden ist, umfasst, aus dem ein Verdampfen des Lösemittels resultiert.

3. Verfahren nach dem vorhergehenden Anspruch, **dadurch gekennzeichnet, dass** der Wärmebehandlungsschritt (E2-5) Folgendes umfasst:
• eine erste Phase, bei der der Träger (2) und die abgeschiedene Lösung einer ersten Temperatur unterworfen werden, die zwischen 40 °C und 80 °C liegt, insbesondere gleich 60 °C ist, während einer ersten Zeit, die zwischen 1 Sekunde und 360 Sekunden liegt, insbesondere gleich 300 Sekunden ist, dann
• eine zweite Phase, bei der der Träger (2) und die abgeschiedene Lösung einer zweiten Temperatur unterworfen werden, die zwischen 80 °C und 120 °C liegt, insbesondere gleich 100 °C ist, während einer zweiten Zeit, die zwischen 1 Sekunde und 500 Sekunden liegt, insbesondere gleich 300 Sekunden ist, dann
• eine dritte Phase, bei der der Träger (2) und die abgeschiedene Lösung einer dritten Temperatur unterworfen werden, die zwischen 100 °C und 300 °C liegt, insbesondere gleich 140 °C ist, während einer dritten Zeit, die zwischen 1 Sekunde und 3600 Sekunden liegt, insbesondere gleich 1800 Sekunden ist.

4. Verfahren nach einem der Ansprüche 2 bis 3, **dadurch gekennzeichnet, dass** aus der Umsetzung des Wärmebehandlungsschritts das Schmelzen (E2-4) des metallischen Materials (5) resultiert.

5. Verfahren nach einem der vorhergehenden Ansprüche, **dadurch gekennzeichnet, dass** der Thermoformungsschritt (E4) das Schmelzen (E3) des metallischen Materials (5) bewirkt, und dass nach dem Thermoformungsschritt (E4) alle oder ein Teil der metallischen Partikel (4) der Einheit metallischer Partikel miteinander durch das metallische Material (5) verschweißt sind.

6. Verfahren nach einem der vorhergehenden Ansprüche, **dadurch gekennzeichnet, dass** der Abscheidungsschritt (E2-2) der Lösung auf dem Träger (2) derart ist, dass ein Muster hergestellt wird, das dazu bestimmt ist, mindestens einen Antennen- oder Spulenteil abzugrenzen.

7. Verfahren nach einem der vorhergehenden Ansprüche, **dadurch gekennzeichnet, dass** das metallische Material (5) aus den folgenden Legierungen ausgewählt ist: Ag-Bi, Ag-Sn-Bi, Ag-Sn-Cu, Au-Sn.

8. Verfahren nach einem der vorhergehenden Ansprüche, **dadurch gekennzeichnet, dass** es einen Schritt des Bildens (E5) des zu liefernden Trägers (2) umfasst, der einen Schritt des Lieferns (E5-1) einer Basis und einen Schritt des Bildens (E5-2) einer Haftschicht (7) umfasst, die dazu bestimmt ist, eine Schnittfläche zwischen der elektrisch leitenden Bahn (3) und der Basis (6) zu bilden.

9. Vorrichtung (1), die einen Träger (2) und eine elektrisch leitende Bahn (3), die auf dem Träger (2) angeordnet ist, umfasst, wobei die elektrisch leitende Bahn (3) eine Einheit metallischer Partikel (4) umfasst, wobei metallische Partikel (4) der Einheit metallischer Partikel elektrisch miteinander durch Schweißung aus einem metallischen Material (5) der Bahn (3) verbunden sind, wobei das metallische Material (5) eine Schmelztemperatur aufweist, die kleiner ist als die der metallischen Partikel (4) der Einheit metallischer Partikel, **dadurch gekennzeichnet, dass** der Träger (2) eine Form annimmt, die durch Thermoformen erhalten wird, wobei sich die elektrisch leitende Bahn (3) an die Form des Trägers (2), die durch Thermoformen erhalten wird, anlegt.

10. Vorrichtung nach dem vorhergehenden Anspruch, **dadurch gekennzeichnet, dass** mindestens ein Teil des Trägers (2) aus einem Material, das angepasst ist, um thermogeformt zu werden, gebildet ist.

11. Verfahren nach einem der Ansprüche 9 bis 10, **dadurch gekennzeichnet, dass** das metallische Material aus den folgenden Legierungen ausgewählt ist: Ag-Bi, Ag-Sn-Bi, Ag-Sn-Cu, Au-Sn.

12. Vorrichtung nach einem der Ansprüche 9 bis 11, **dadurch gekennzeichnet, dass** die metallischen Partikel maximale Außenmaße zwischen 30 nm und 30 µm aufweisen und bevorzugt zwischen 1 µm und 10 µm liegen.

13. Vorrichtung nach einem der Ansprüche 9 bis 12, **dadurch gekennzeichnet, dass** die elektrisch leitende Bahn (3) mindestens einen Teil einer Antenne oder mindestens einen Teil einer Spule bildet.

14. Vorrichtung nach einem der Ansprüche 9 bis 13, **dadurch gekennzeichnet, dass** der Träger (2) eine Basis (6) und eine Haftschicht (7), die auf der Basis (6) abgeschieden ist und ein Halten der elektrisch leitenden Bahn (3) auf dem Träger (2) sicherstellt, umfasst.

## Claims

1. Method for fabricating a device (1) comprising an electrically conducting track (3) arranged on a support (2), said method comprising a step of supply (E1) of the support (2), and a step of formation (E2) of the electrically conducting track (3) on the support (2) comprising the following steps:
- a step of supply (E2-1) of a solution intended to be deposited on the support (2),
- a step of deposition (E2-2) of the solution by printing on the support (2), the step of supply (E2-1) of the solution being such that said solution supplied comprises a mixture of a solvent, of a set of metal particles (4) and of a metallic material (5) having a melting point below that of the metal particles (4) of the set of metal particles, said method comprising a step of melting (E2-4, E3) of the metallic material (5) which results in the formation of a solder of metallic material (5) between metal particles (4) of the set of metal particles,
**characterized in that** at least one part of the support (2) is capable of being thermoformed, and **in that** after the step of formation (E2) of the electrically conducting track (3) on the support (2), the method comprises a step of thermoforming (E4) of said at least one part of the support (2).

2. Method according to the preceding claim, **characterized in that** the step of formation (E2) of the electrically conducting track (3) on the support (2) comprises a step of heat treatment (E2-5) of the solution deposited on the support (2) which results in evaporation of the solvent.

3. Method according to the preceding claim, **characterized in that** the heat treatment step (E2-5) comprises:
• a first phase in which the support (2) and the solution deposited are subjected to a first temperature comprised between 40°C and 80°C, notably equal to 60°C, for a first time comprised between 1 second and 360 seconds, notably equal to 300 seconds, then
• a second phase in which the support (2) and the solution deposited are subjected to a second temperature comprised between 80°C and 120°C, notably equal to 100°C, for a second time comprised between 1 second and 500 seconds, notably equal to 300 seconds, and then
• a third phase in which the support (2) and the solution deposited are subjected to a third temperature comprised between 100°C and 300°C, notably equal to 140°C, for a third time comprised between 1 second and 3600 seconds, notably equal to 1800 seconds.

4. Method according to any one of Claims 2 to 3, **characterized in that** it results in implementation of the heat treatment step melting (E2-4) of the metallic material (5).

5. Method according to any one of the preceding claims, **characterized in that** the thermoforming step (E4) causes melting (E3) of the metallic material (5), and **in that**, after the thermoforming step (E4), some or all of the metal particles (4) of the set of metal particles are soldered together by said metallic material (5).

6. Method according to any one of the preceding claims, **characterized in that** the step of deposition (E2-2) of the solution on the support (2) is such that a pattern is produced that is intended to delimit at least one part of an antenna or inductance.

7. Method according to any one of the preceding claims, **characterized in that** the metallic material (5) is selected from the following alloys: Ag-Bi, Ag-Sn-Bi, Ag-Sn-Cu, Au-Sn.

8. Method according to any one of the preceding claims, **characterized in that** it comprises a step of formation (E5) of the support (2) to be supplied comprising a step of supply (E5-1) of a base and a step of formation (E5-2) of a hanging layer (7) intended to form an interface between the electrically conducting track (3) and the base (6).

9. Device (1) comprising a support (2) and an electrically conducting track (3) arranged on the support (2), said electrically conducting track (3) comprising a set of metal particles (4), metal particles (4) of the set of metal particles being joined together electrically by soldering with a metallic material (5) of said track (3), said metallic material (5) having a melting point below that of said metal particles (4) of the set of metal particles, **characterized in that** the support (2) takes a shape obtained by thermoforming, said electrically conducting track (3) taking on said shape of the support (2) obtained by thermoforming.

10. Device according to the preceding claim, **characterized in that** at least one part of the support (2) is formed from a material capable of being thermoformed.

11. Device according to any one of Claims 9 to 10, **characterized in that** the metallic material is selected from the following alloys: Ag-Bi, Ag-Sn-Bi, Ag-Sn-Cu, Au-Sn.

12. Device according to any one of Claims 9 to 11, **characterized in that** the metal particles have maximum external dimensions comprised between 30nm and 30µm, and preferably comprised between 1µm and 101µm.

13. Device according to any one of Claims 9 to 12, **characterized in that** the electrically conducting track (3) forms at least one part of an antenna or at least one part of an inductance.

14. Device according to any one of Claims 9 to 13, **characterized in that** the support (2) comprises a base (6) and a hanging layer (7) arranged on the base (6) and ensures that the electrically conducting track (3) is held on said support (2).
